Europäisches Patentamt

European Patent Office

Office européen des brevets

(11) Publication number: **0 304 699**
**A2**

# EUROPEAN PATENT APPLICATION

(21) Application number: **88112746.8**

(22) Date of filing: **04.08.88**

(51) Int. Cl.4: **H01B 3/44** , **C08J 9/32**

(30) Priority: **28.08.87 JP 214604/87**

(43) Date of publication of application:
**01.03.89 Bulletin 89/09**

(84) Designated Contracting States:
**AT CH DE FR IT LI NL SE**

(71) Applicant: **JUNKOSHA CO. LTD.**
**25-25, Miyasaka 2-chome**
**Setagaya-ku Tokyo 156(JP)**

(72) Inventor: **Satoh, Yoshiaki**
**350-7, Kawadera**
**Hannoh-shi Saitama(JP)**

(74) Representative: **Kehl, Günther, Dipl.-Phys. et al**
**Patentanwälte HAGEMANN & KEHL**
**Ismaninger Strasse 108 Postfach 860329**
**D-8000 München 86(DE)**

(54) Composite material of low dielectric constant and method of producing it.

(57) A composite material of low dielectric constant, having minute hollow spheres of insulating material dispersed in a fibrous Polytetrafluoroethylene. The composite material has high mechanical strength.

EP 0 304 699 A2

# COMPOSITE MATERIAL OF LOW DIELECTRIC CONSTANT AND METHOD OF PRODUCING IT

This invention relates to a composite material of low dielectric constant, having electric properties improved by incorporation therein of minute hollow spheres.

It is well known that polytetrafluoroethylene (hereinafter referred to as "PTFE") possesses highly desirable electric properties, thermal stability, and chemical resistance and by virtue thereof, has found extensive utility in numerous applications. Concerning the use of the PTFE in an electric insulating material, for example, the feasibility of using the PTFE in a highly porous form for the purpose of imparting improved electric properties to the insulating material is being considered.

As regards the method for production of porous PTFE, since the PTFE in a molten state exhibits extremely high viscosity, it defies adoption of any of the conventional methods such as physical foaming by the forced introduction of an inert gas or chemical foaming by the use of a foaming agent which have heretofore been popularly practiced on thermoplastic resins or other fluorocarbon resins. Thus, the production of porous PTFE has no alternative but to rely on some special method or other. As examples of such special methods, there can be cited a method which comprises thoroughly mixing PTFE with a substance removable by extraction or solution, pressure forming the resultant mixture, and subsequently removing the substance from the formed article (Japanese Patent Publication SHO 35(1960)-13,043), a method which comprises mixing fine PTFE powder with a liquid lubricant, forming the resultant mixture under conditions capable of exerting such shear strength as extrusion or rolling, then removing the liquid lubricant from the formed article, and subsequently drawing and sintering the formed article (Japanese Patent Publication SHO (42(1967)-13,560, SHO 56-(1981)-17,216, and SHO 57(1982)-30,057) and a method which comprises drawing an unsintered formed article of PTFE in a liquid such as halogenated hydrocarbon, petroleum type hydrocarbon, alcohol, ketone which is capable of wetting PTFE and subsequently sintering the drawn wet formed article.

Though various methods have been proposed for the production of porous PTFE as described above, the porous articles obtained by these methods invariably have intercommunicating pores. They function advantageously as filters, for example. When these porous articles are produced in the form of tapes, sheets, etc. and used as insulators for electric wires, printed boards, etc., however, the insulators have a disadvantage that the mechanical strength, particularly the strength to resist compression, manifested by the insulators sharply decreases, the dimensional stability notably declines, and the stability of electric properties diminishes in proportion as the porosity of the porous articles increases.

Further, as one common drawback, all these conventional methods entail the great difficulty in the control of pore diameter and porosity to be obtained in the porous articles they produce. Thus, these methods have room for further improvement in workability.

In view of the drawback inherent in the prior art as described above, this invention aims to solve the problem to provide a composite material of low dielectric constant formed in porous texture with PTFE, which composite article suffers only slight change in mechanical strength due to an increase in porosity, maintains electric properties stably, and permits easy control of porosity and easy forming during the course of production.

For the solution of the aforementioned problem the invention contemplates a composite material of low dielectric constant, having minute hollow spheres made of insulating material and dispersed in a fibrous polytetrafluoroethylene.

The fibrous polytetrafluoroethylene used in the present invention is a resin possessing a fine fibrous texture and obtained when unsintered PTFE particles are shaped under the conditions capable of exerting shear strength such as rolling.

The minute hollow spheres to be used in the present invention are made of an insulating material such as glass, plastic, or rubber and are desired to possess particle diameters in the range of 1 to 300 $\mu$m. Among other hollow spheres answering the foregoing description, those made of glass having a silicon dioxide content of not less than 80 % prove to be particularly desirable. Since the hollow spheres have such a gas as $N_2$ or $CO_2$ sealed therein, the composite material has low specific gravity and low dielectric constant. In the present invention, the amount of the minute hollow spheres to be incorporated in the composite material is not particularly restricted but may be properly selected to suit the material of the spheres or the use for which the composite material is intended. When the composite material is used as an electric insulating material, for example, it is desirable from the standpoint of effect of incorporation to select this amount approximately in the range of 50 to 95 % by weight based on the amount of the composite material. Where the use for which the composite material is intended requires mechanical strength in particular, the minute hollow spheres may be given a surface treatment with a coupling agent in advance of use.

In accordance with this invention, the characteristic of creep inherent in the polytetrafluoroethylene enables the composite material to occlude a large bulk of minute hollow spheres therein. Further, since minute hollow spheres of low dielectric constant made of such insulating material as glass or plastic and having such a gas as $N_2$ or $CO_2$ sealed therein are dispersed in a fibrous polytetrafluoroethylene, what is consequently obtained is a polytetrafluoroethylene composition of a porous texture containing discrete pores. The composite material, therefore, possesses very low dielectric constant and high mechanical strength.

The fine PTFE powder destined to serve as a raw material for the fi brous PTFE composite assumes a fine fibrous texture when it is subjected in an unsintered state to shear strength as when it is extruded through a die during the course of extrusion, drawn out with a roll, or stirred with blades, for example. The resin, in a state containing a liquid lubricant, has the nature of easily assuming a fibrous form and undergoing plastic deformation and, therefore, can be formed readily by rolling or extrusion, for example. The formed article consequently obtained, even in an unfired state, is possessed of fairly high mechanical strength because the PTFE particles are oriented after the pattern of fibers and are intertwined to give rise to a fibrous texture during the course of forming. When a large bulk of minute hollow spheres is added to the resin at this stage, the resin is allowed to retain its inherent nature of yielding to plastic deformation, because the individual PTFE particles in the unsintered state are not completely integrated. This explains why the composite material can be formed by rolling or extrusion. Moreover, the composite material is prevented from appreciably losing mechanical strength, because of the fibrous texture formed of PTFE.

Other fluorocarbon resin such as, for example, an ethylene tetrafluoridepropylene hexafluoride copolymer resin suffers from sharp rise of melt viscosity and fall of flowability when it is mixed with minute hollow spheres. By reason of moldability, the upper limit of the amount of minute hollow spheres tolerated to be incorporated in this resin is approximately 10 % by weight at most.

This invention, originating in the finding that the fine unsintered PTFE powder is easily converted into fibers and plastically deformed even after it has incorporated therein a large bulk of minute hollow spheres and, moreover, the formed article of the resin consequently obtained possesses the nature of retaining proper mechanical strength, aims to allow the composite material to acquire low dielectric constant by causing minute hollow spheres of low dielectric constant to be retained as in voids between the fibers of the PTFE resin now in a fibrous texture.

To be specific, when an intimate mixture of fine unsintered PTFE powder and minute hollow spheres is formed under conditions capable of exerting shear strength such as extrusion or rolling, the PTFE forms a fibrous texture and the minute hollow spheres are dispersed and lodged in the voids between the fibres of the PTFE. When the formed article of mixture is sintered, the two components of the mixture are united strongly with the minute hollow spheres held fast between the fibers of PTFE. Thus, there is completed a porous PTFE containing discrete pores. Under working conditions not requiring any appreciably high mechanical strength, the composite material may be used in an unsintered state or in an incompletely sintered state.

What is consequently obtained, therefore, is a composite material of low dielectric constant. This dielectric constant of the composite material can be easily controlled to a desired level by selecting the particle diameter and the amount of incorporation of minute hollow spheres. Further, since the porous texture is such that the individual pores exist independently of each other, there is no possibility of the individual pores being crushed or deformed under such external force as compression. This porous texture contributes to enhancing the dimensional stability of the composite material. When the composite material is used as an insulating material for electric wires, cables, and printed boards, for example, it exhibits desirable electric properties and, at same time, retains its inherent properties stably under the aforementioned external force, and contributes immensely to improvement of performance. In this case, when the formed article of unfired PTFE possessing the fibrous texture is subjected to complete firing, the mechanical strength thereof is increased to a great extent.

When the minute hollow spheres are treated with a coupling agent, this treatment imparts oil-appetency to the surface of the minute hollow spheres. They, consequently, exhibit increases affinity for the fibrous polytetrafluoroethylene which forms the matrix of the composite material and are highly effective in enhancing the mechanical strength of the finally produced composite material.

Now, the composite material of low dielectric constant according to the present invention will be described more specifically below with reference to working examples.

## Example 1:

Seventy (70) percent by weight of minute hollow spheres of glass having an average particle diameter of 25 μm (produced by Fuji Davison Chemical Co., Ltd. and marketed under product code of "H-101") and 30 percent by weight of fine powder of polytetrafluoroethylene (produced by Mitsui DuPoint Fluorochemical Co., Ltd. and marketed under trademark designation of "Teflon 6J") were mixed with each other and subsequently mixed further with solvent naphtha (produced by Idemitsu Petrochemical Co., Ltd. and marketed under product code of "I-1620") as a liquid lubricant serving to impart moldability to the resin and facilitating conversion of the resin into fibres. The final mixture was left standing at normal room temperature for 12 hours.

Then, the aged mixture was stirred for slight conversion into fibers and drawn out with a roll to promote the conversion into fibers, forming to a sheet 0,15 mm in thickness. The sheet was heated to expel the liquid lubricant and then sintered at 370°C for three minutes to obtain a composite material of low dielectric constant as contemplated by the present invention.

The sheet of composite material thus obtained exhibited appreciably high electric properties as evinced by a dielectric constant of 1,5, enjoyed freedom from such drawbacks as collapse of pores or loss of dimensional stability which are frequently observed in the conventional porous PTFE sheet containing intercommunicating pores, and manifested notably improvement in the stability of electric properties. Thus, it was found to suit use as an electric insulating material.

## Example 2:

A composite material was obtained by following the procedure of Example 1, excepting the minute hollow spheres of glass (produced by Fuji Davison Chemical Co., Ltd. and marketed under product code of "H-101"), used in 70 percent by weight, were given a surface treatment with 1 percent by weight of a silane coupling agent (produced by Daihachi Chemical Co., Ltd., and marketed under product code of "RT-18E") before use.

The composite material thus produced possessed a dielectric constant of 1,8, a value higher than that of the composite material of Example 1. The minute hollow spheres, owing to the oil-appetancy imparted to their surface by the coupling agent, were enabled to increase the degree of union thereof with the fibrous PTFE constituting the matrix of the composite material and improved the mechanical properties of the produced composite material.

As the coupling agent, a titanate coupling agent can be used as effectively as the silane coupling agent. The kind and the amount of the coupling agent are selected so as to suit the material of the minute hollow spheres and the use for which the composite material of low dielectric constant is intended. Where the virtue of low dielectric constant constitutes a main target, the amount of the coupling agent to be used is desired to be as small as possible. At times, the use of the coupling agent may be omitted.

As examples of the insulating substance of which the minute hollow spheres are made, there can be cited glass, minute mineral balloons originating in volcanic ashes, plastics, and rubber. One member or a mixture of two or more members selected from the group of substance enumerated above can be used. Among other possible minute hollow spheres of various substances, those made of glass having the silicon dioxide content thereof increased to a level above 80% as by an acid treatment prove to be particularly desirable because of their notably low dielectric constant of 1,2. Where such a high polymer material as plastic or rubber is contemplated, it is desirable to employ a plastic material such as polyimide type resin or fluorine type rubber which enjoys high thermal stability in due consideration of the intense heat to be used during the course of sintering. Where the production of the composite material does not involve the treatment of firing, a plastic material such as polyethylene or polystyrene which has no very high thermal stability may be used. The particles diameter and the amount of use of these minute hollow spheres can be properly selected so as to suit the use for which the composite material is intended and the substance of which the minute hollow spheres are made. Generally, the particle diameter is desired to fall in the range of 1 to 300 μm. The amount of minute hollow spheres is in the range of 50 to 95 wt % according to the effect of incorporation of the spheres and/or the mechanical strength of the product.

Now, the method of forming to be followed in the conversion of PTFE into fibers will be explained with reference to several examples. The unsintered PTFE has the nature of assuming a fine fibrous texture on exposure to shear strength. This conversion of the unsintered PTFE into fibers is facilitated by the addition of a liquid lubricant. For the sake of this invention, this conversion of the PTFE into fibers constitutes itself one of the important requirements. The stable retention of the large bulk of minute hollow spheres in the composite material is materialized by improving the mechanical strength of PTFE as the matrix resin owing to the conversion thereof into fibers. The unsintered PTFE containing the minute hollow spheres, therefore, must be formed by the method of extrusion, the method of rolling, or the combination of both methods to be described below, so as to suit the use for which the finally produced composite material is intended.

(a) Forming of rod, tube, sheet, etc. by extrusion:

This operation can be carried out by the conventional method using a ram type extruding machine. Generally, for the purpose of facilitating the supply of a thorough mixture of minute hollow spheres, fine powder of unsintered PTFE, and a liquid lubricant to the extruding machine and ensuring homogenization of a formed product, the aforementioned mixture is preparatorily compression molded and then supplied to the extruding machine. The mixture may be otherwise extruded, rolled, or stirred in a fluid to effect slight conversion of the PTFE into fibers before it is finally formed by extrusion.

(b) Forming of sheet and film by rolling:

A thorough mixture of PTFE with a liquid lubricant and minute hollow spheres as prepared in the form of powder or in a preparatorily compression molded form is passed between rolls to produce a sheet. Again in this case, the mixture may be preparatorily stirred to effect slight conversion of the PTFE into fibers before it is finally formed by compression. Generally, one rolling neither produces any sufficient conversion of PTFE into fibers nor enables the PTFE to acquire any sufficient tensile strenth for retaining the minute hollow spheres fast in position, the rolling is desired to be repeated until sufficient conversion of PTFE into fibers will be attained. Optionally, two or more sheets produced by compression may be superposed on the top of another and subjected to final rolling. The sheet rolled in two perpendicular directions, namely in the direction of width and the direction of lenghth, possesses higher strength and better quality than the sheet rolled in one direction. Thus, the number of rolling cycles and the number of directions of rolling may be properly increased to suit the use for which the finally produced formed article is intended. The sheet obtained by the present method ceases to exhibit directionality and acquires enhanced dimensional stability when it is sintered. When the sintered sheet is used as an insulating material in a printed board, for example, it has an advantage that the otherwise possible phenomenon of warping does not occur.

(c) Forming by the combination of extrusion and rolling:

The rod, sheet, etc. which has been formed by extrusion as indicated in (a) is rolled by being passed between rolls. In this case, it does not matter whether the direction of rolling is identical with that of extrusion or not. It is of course permissible to repeat the treatment of rolling several times.

The forming effected by any of the methods described above is essentially carried out at a temperature not exceeding 327°C, the melting point of PTFE, preferably at a temperature near normal room temperature. The PTFE mixture which has been formed in a prescribed shape by any of the methods described above is heated for expulsion of the liquid lubricant and then sintered to give rise to a composite material of low dielectric constant as aimed at by this invention. The composite material may be produced in an incompletely sintered form or in a completely unsintered state, depending on the use for which the composite material is intended.

Incidentally, the conventional porous PTFE material must be given a surface treatment with an ammonia solution of sodium metal or with a naphthalene solution of tetrahydrofuran so as to aquire improved adhesiveness or wettability before it is subjected to a treatment of adhesion or plating. The composite material of low dielectric constant according to the present invention, particularly when the amount of minute hollow spheres incorporated therein is increased, brings about an effect of obviating the necessity for such a surface treatment as mentioned above. A logical explanation of this effect may be offered by a postulate that numerous minute hollow spheres occupy the voids occurring between the minute fibers formed by the method described above, the fibrous PTFE mainly functions as a binder of the individual minute hollow spheres, and numerous minute hollow spheres are therefore allowed to look out of the surface of the formed composite material and impart adhesiveness and wettability to the surface of the final product.

The composite material of this invention, as described in detail above, has minute hollow spheres of light dielectric constant dispersed in a matrix of fibrous ethylene tetrafluoride resin and, therefore, exhibits a low dielectric constant. The dielectric constant of the produced composite material can be controlled to a desired level by selecting the particle diameter and the amount of incorporation of the minute hollow spheres. Thus, the composite material provided by this invention is used advantageously as an electric insulating material.

Further, the composite material possesses a porous texture containing discrete pores. When the composite material is produced in a form incorporating the minute hollow spheres in an increased amount to lower the dielectric constant, it enjoys highly desirable dimensional stability because it is not easily crushed unlike the conventional countertype, i.e. a composite material of porous polytetrafluoroethylen containing intercommunicating pores. Owing to the high dimensional stability, the composite material enjoys a great advantage that the electric properties thereof are retained intact.

When the amount of minute hollow spheres to be incorporated in the composite material is increased, the produced composite material is allowed to manifest adhesiveness and wettability on the surface thereof. When this composite material is used as an insulating material in a printed board, for example, it brings about an advantage that it can be safely and effectively plated without requiring the through hole part thereof to be given any special surface treatment.

The present invention need not be limited to the working examples cited above but may be modified or altered variously as by the variation in the amount of use and the particle diameter of the minute hollow spheres, without departing from the technical idea of the invention.

## Claims

1. Composite material of low dielectric constant, characterized by minute hollow spheres of insulating material dispersed in a fibrous Polytetrafluoroethylene.

2. Composite material according to claim 1, characterized in that said minute hollow spheres are formed of an insulating material selected from the group consisting of glass, plastics, and rubber.

3. Composite material according to claim 2, characterized in that said glass has a silicon dioxide content of not less than 80 %.

4. Composite material according to any of claims 1 to 3, characterized in that said minute hollow spheres have undergone a surface treatment with a coupling agent.

5. The composite material according to any of claims 1 to 4, characterized in that the content of said minute hollow spheres in said composite material is in the range of 50 to 95% by weight.

6. Method of producing the composite material according to anyone of claims 1 to 5, characterized by mixing minute hollow spheres and fine powder of PTFE, drawing out the mixture to form a sheet, finally heating and sintering the sheet.

7. Method according to claim 6, characterized in that a lubricant agent is added before drawing out the mixture.

8. Method according to claim 6 or 7, characterized in that the minute hollow spheres are glass spheres.

9. Method according to claim 8, characterized in that the glass spheres are given a surface treatment with a coupling agent.

10. Method according to anyone of claims 6-9, characterized in that the diameter of the spheres is in the range of 1 um to 300 $\mu$m.